# EUROPEAN PATENT APPLICATION

(11) **EP 1 473 109 A1**
(43) Date of publication of application: **03.11.2004**
(21) Application number: 04252478.5
(22) Date of filing: 29.04.2004
(51) Int. Cl.: B23K 35/00, B23K 35/02, B23K 35/26, H01L 23/373, H01S 5/02, B32B 15/04, H05K 3/34

(54) **Solder film manufacturing method, heat sink furnished with solder film, and semiconductor device and heat sink junction**

(30) Priority: 01.05.2003 JP 2003126616
(71) Applicant: SUMITOMO ELECTRIC INDUSTRIES, Ltd, Osaka-shi, Osaka 541-0041 (JP)
(72) Inventor: Itakura, Katsuhiro, c/o Itami W. of S.E. Ind.,Ltd., Itami-shi, Hyogo (JP); Chiba, Yukifumi, c/o Sumitomo E. Fine Polymer,Inc., Sennan-gun, Osaka (JP); Fujii, Satoshi, c/o Itami W. of S.E. Ind., Ltd., Itami-shi, Hyogo (JP)
(74) Representative: Cross, Rupert Edward Blount

(57) **Abstract**

The solder film manufacturing method has a step for laminating a plurality of unit layers, each unit layer formed by laminating a plurality of layers including layers of only Zn, Bi or Sn, or layers of alloys of two of the metals Zn, Bi and Sn. This manufacturing method also preferably also has a step for forming an Sn layer as the top surface layer. A heat sink has a solder film manufactured by this process. A solder junction connects a semiconductor device characterized by having a semiconductor element mounted on this heat sink with a heat sink having this solder film.

## Description

The present invention relates to a method for manufacturing lead-free solder films composed of Zn, Bi and Sn; to semiconductor-device-bonding heat sinks furnished with lead-free solder films; and to semiconductor-device-and-heat-sink junctions. The present invention relates more particularly to methods of manufacturing a lead-free solder film advantageously utilized in bare-chip mounting of laser diode chips and in like applications, to heat sinks furnished with lead-free solder films, and to semiconductor-device-and-heat-sink junctions wherein semiconductor devices are mounted on a heat sink.

### Description of the Background Art

Electronic components using laser diodes are manufactured with the laser diode chip bare-chip mounted on a heat sink for eliminating heat that emanates from the chip. Bare chip mounting is carried out according to a method in which a solder film is formed on the surface of a metallized heat sink, and onto that a laser diode chip is joined by die bonding, solder reflow, or other chip-bonding technique.

Laser diode chips are vulnerable to heat, such that their lasing characteristics are prone to being compromised due to heat. Thus, in order to prevent thermal degradation to a laser diode chip when it is being mounted, the temperature in mounting it onto a heat sink must be kept low. With the solder film formed on the surface of a heat sink consequently having to be of low melting point (eutectic point), conventionally Sn-Pb eutectic solder (eutectic point: 183°C) has been used. However, solder containing lead, which is toxic to humans, is undesirable due to environmental concerns, and extensive research has been directed in recent years to developing alternative solders that do not contain lead, that is, Pb-free solders.

The melting point of many conventional Pb-free solders is, however, higher than that of Sn-Pb eutectic solder (280°C for Au-Sn solder, and 220°C for Sn-Ag solder, for example), which consequently gives rise to the problem of degrading the lasing characteristics of a laser diode chip when it is being mounted.

Pb-free solders from multi-component (ternary, quaternary, etc.) alloys, having melting points comparable to Sn-Pb eutectic solder, have recently been developed. Solders for packaging applications (assembly of chips onto printed circuit boards), composed of Zn, Bi and Sn as principal components, are disclosed as the subject matter of claim 1 in Japanese Pat. No. 3,232,963 and in Japanese Pat. No. 3,340,021; the solders are commercially available as solder-paste products directed to packaging. Nevertheless, in packaging employing these solders flux is used, yet in bare-chip mounting applications flux, being a cause of chip contamination, cannot be used. Meanwhile, it has been assumed that such solders cannot be utilized in bare-chip mounting applications because if the solders were used fluxless, the fusibility and wettability would be poor, making solder reflow attachment problematic.

Furthermore, with the size of laser diode chips that are bare-chip mounted onto heat sinks being a tiny 200 µm or so, 20 µm or less is demanded for their positioning precision. Solder films for semiconductor device mounting are conventionally formed by paste printing techniques, but such positioning precision cannot be handled with those techniques.

Given these demands, the photolithography-based technique is conceivable for forming solder films with such high positioning precision. Specifically, the technique forms a solder film onto a patterned resist layer by vapor deposition or plating, from which a partialized solder film where laser diode chips or other semiconductor devices will be mounted is created by a lift-off process. A semiconductor-device-mounting solder film can thus be formed with an outstanding positioning precision of 20 µm or less by this method.

Nevertheless, inasmuch as the vapor-deposition and plating rates among Zn, Bi and Sn differ, applying the photolithography-based technique to a solder composed of Zn, Bi and Sn leads to problems in that controlling the solder composition and melting point proves to be difficult. For example, when vapor-depositing Zn, Bi and Sn, the deposition rate increases in the order Sn, Bi, Zn; with Zn in particular the deposition rate is very great relative to the other two metals, and while the deposition rate of Bi is lower than that of Zn, it is still significantly greater than Sn. As a result, if a thick solder film is formed in a single deposition, the Zn layer, Bi layer, and Sn layer will separate, and the low melting point that solder should have cannot be realized. It is therefore difficult to achieve an alloy of the desired composition, let alone the desired melting point.

An object of the present invention is to resolve such problems with the conventional technologies and make available a method by a solder film composed of Zn, Bi and Sn having a desired composition and melting point can be manufactured by vapor deposition, plating or the like without any attendant difficulties controlling the composition or the melting point.

A further object of the invention is to make available a heat sink furnished with a solder film that has a specific composition, the heat sink being suitable for bare chip mounting of laser diode chips and other semiconductor devices that are susceptible to thermal degradation.

A yet further object of the invention is to afford a junction, characterized in that this heat sink is utilized, between a heat sink and a semiconductor device.

The present inventors discovered as a result of investigations that by forming a laminate (called a "unit layer" in the present specification) of thin films made from either Zn, Bi or Sn singly, or an alloy composed of two metals selected from Zn, Bi and Sn, and repeating formation of the unit layers-that is, by laminating unit layers to form a solder film-the foregoing problems can be resolved.

In particular, the present invention in a first aspect affords a solder-film manufacturing method characterized in having a process for multi-laminating unit layers formed by laminating a plurality of types of laminae made from either Zn, Bi or Sn singly, or an alloy composed of two metals selected from Zn, Bi and Sn.

A solder film manufactured by this method is one in which unit layers are multi-laminated, each unit layer being one in which are laminated a plurality of types of laminae selected from an Zn lamina, a Bi lamina, an Sn lamina, and a lamina of an alloy composed of two kinds selected from these metals. Each unit layer is created by a process of forming respective laminae, which is repeated with the lamina being changed, and by laminating the laminae.

Since according to this method a lamina for each metal Zn, Bi and Sn or each alloy composed of two among these metals is formed, the composition as a post-lamination entirety can be readily regulated by adjusting the thickness of the lamina. A desired composition can therefore be easily produced, which makes for facilitated control of the composition and control of the melting point.

Seen metal lamina by metal lamina, this solder film does not consist of an alloy having a solder composition. However, by making the respective laminae thin, a melting point as a unit-layer entirety close to the melting point of an alloy having the same composition is obtained.

Furthermore, if the unit layers are constituted substantially from Zn, Bi and Sn, a solder melting point is achieved in each unit layer, and a melting point near the melting point of a solder having the same composition can advantageously be obtained in the solder film as a whole.

What is more, if a solder film is formed by laminating unit layers having the same constitution, the solder-film constitution along the thickness will be uniform, consequently producing uniformity as regards melting point, which is advantageous in that for the solder film as a whole a melting point near the melting point of a solder having the same composition is readily obtained.

The present invention in second and third aspects corresponds to these preferable modes.

More specifically, the invention in a second aspect affords a manufacturing method that is the solder-film manufacturing method described in the first aspect, while being characterized in that the unit layers are constituted substantially from Zn, Bi and Sn.

Likewise, the invention in a third aspect affords a manufacturing method that is the solder film manufacturing method described in the first aspect, while being characterized in that the laminar structure constituting the unit layers is substantially the same in each unit layer.

In a fourth aspect the present invention affords a solder-film manufacturing method characterized in including: a process of forming a single one of whichever of a Zn lamina, a Bi lamina, an Sn lamina, an alloy lamina of Zn and Sn, or an alloy lamina of Bi and Sn; a process of forming a unit layer composed of Zn, Bi and Sn by repeating this single-lamina formation process while changing what the lamina is, and laminating the laminae; and a process of repeating this unit-layer formation process to laminate the unit layers.

A solder film manufactured by this method is one in which unit layers composed of Zn, Bi and Sn are multi-laminated.

Furthermore, each unit layer is one in which are laminated a Zn lamina, a Bi lamina, an Sn lamina, an alloy lamina of Zn and Sn, and/or an alloy lamina of Bi and Sn, each unit layer is built by the process of forming respective laminae, which is repeated with the lamina being changed, and by laminating the laminae. This means that all metals Zn, Bi and Sn are contained in whichever of the laminae in a unit layer.

The invention in a fifth aspect affords a solder-film manufacturing method that is the solder-film manufacturing method of the fourth aspect, while being characterized in that in that the process of forming the unit layer is made up of the steps of forming laminae in the order Zn lamina, Sn lamina, Bi lamina, Sn lamina, or the order Bi lamina, Sn lamina, Zn lamina, Sn lamina.

The order in which the Zn lamina, Bi lamina and Sn lamina are formed is not particularly limited insofar as a unit layer containing all of the metals Zn, Bi and Sn in a desired composition is produced. Nevertheless, preferable is a method in which respective laminae are formed in the order Zn lamina, Sn lamina, Bi lamina, Sn lamina, or the order Bi lamina, Sn lamina, Zn lamina, Sn lamina. More specifically, a melting point that is near the melting point of a solder having the same composition as the overall composition of the unit layer can be more easily achieved by inserting the Sn-lamina formation step between the Zn-lamina formation step and the Bi-lamina formation step. More preferably still is the order Zn lamina, Sn lamina, Bi lamina, Sn lamina.

The invention in a sixth aspect affords a solder-film manufacturing method that is the solder-film manufacturing method of the fourth aspect, while being characterized in that the process of forming the unit layer includes the step of forming an alloy lamina of Zn and Sn, and/or a step of forming an alloy lamina of Bi and Sn.

Formation of the unit layer can be carried out by, instead of repeating formation of the Zn-lamina, Bi-lamina and Sn-lamina metal laminae, repeating formation of alloy laminae composed of two selected from these metals.

As a mode of repeating the formation of these alloy laminae, a method of repeating a step of forming an alloy lamina of Zn and Sn and a step of forming an alloy lamina of Bi and Sn is preferable; the invention in the sixth aspect is equivalent to this mode.

The order of forming the Zn-and-Sn alloy lamina and of forming the Bi-and-Sn alloy lamina is also not particularly limited insofar as a unit layer containing all the metals Zn, Bi and Sn in the desired composition is obtained.

The epi-surface lamina of the solder film is preferably an Sn lamina. The manufacturing method of the present invention thus preferably includes a step of forming an Sn lamina on the epi-surface layer of the solder film. The invention in the seventh aspect is equivalent to this mode.

The formation of the Zn-lamina, Bi-lamina and Sn-lamina metal laminae, and the formation of alloy laminae composed of two selected from these metals, can be carried out by vapor deposition or plating.

An eighth aspect of the invention is a solder-film manufacturing method as described above, while being characterized in that the unit layers are formed by vapor deposition, and corresponds to a mode in which formation of the Zn-lamina, Bi-lamina and Sn-lamina metal laminae, and the formation of the alloy laminae composed of two selected from these metals, is carried out by vapor deposition.

In a ninth aspect the invention is a solder-film manufacturing method as described above, while being characterized in that the unit layers are formed by plating, and corresponds to a mode in which formation of the Zn-lamina, Bi-lamina and Sn-lamina metal laminae, and the formation of the alloy laminae composed of two selected from these metals, is carried out by plating.

Plating is ordinary electroplating. The metal lamina initially formed on the heat sink can be rendered by electroplating with the metallized heat sink being one electrode.

The invention in a tenth aspect affords a solder-film manufacturing method as described, while being characterized in that the unit layer thickness is 8000 Å or less.

A melting point comparable to the melting point of a solder having the same composition as the composition of the unit-layer entirety cannot be achieved if the gauge of the metal laminae constituting the unit layer is thick. A melting point approaching the melting point of a solder having the desired composition can be achieved by making the gauge of the metal laminae, and in turn the gauge of the unit layer entirety, thin. In particular, the thickness the unit-layer entirety is preferably 8000 Å or less, and further preferably is 5000 Å or less.

A solder film can be produced by laminating such unit layers, but a thickness of some 3 µm or greater is normally necessary. The solder film is therefore preferably formed as a laminate of four or more unit layers, and further preferably as a laminate of six or more unit layers.

In an eleventh aspect the present invention affords a solder-film manufacturing method as described above, while being characterized in including a step of forming a solder film on a patterned resist layer, and patterning the solder film by a lift-off technique after the solder film is formed. This method enables forming on a heat sink a semiconductor-device-mounting solder film with positioning precision of some 20 µm or less, or, depending upon the conditions, of some 5 µm.

The patterned resist film can be formed by photolithography. The resist film is preferably patterned in an inverse taper. The solder film is then formed over this soldering pattern by vapor deposition or plating. The solder film covering the resist pattern is then removed by a lift-off technique, and the remaining solder film becomes the solder film for semiconductor device mounting.

In a twelfth aspect invention affords a heat sink having a solder film manufactured according to a solder-film manufacturing method as described above.

The solder film manufactured by the above-described solder film manufacturing method is appropriately used in applications for mounting on the heat sink semiconductor devices that are susceptible to thermal degradation. The twelfth aspect corresponds to a heat sink in this advantageous mode.

A heat sink is a heat-radiating substrate used to efficiently remove heat generated by devices. AIN (aluminum nitride ceramic), Si, SiC (silicon carbide), and AlN-diamond are widely used as heat sink materials because of their high thermal conductivity, linear expansion coefficient equal to the surrounding material, and low dielectric constant.

Bare chip mounting of semiconductor devices to the heat sink normally involves forming a metal layer on the heat sink (metallization), and then forming the solder film on this metal layer. This metal layer is normally patterned, and a patterned metal layer (i.e., metal pattern) can be formed with good positioning precision and dimensional precision using photolithography and lift-off methods. More specifically, a resist layer preferably patterned in an inverted taper is formed by photolithography, and a metal layer is formed thereon by vapor deposition, for example, and lifted off. The metal layer on the resist pattern is thereby removed, and the part of the metal layer that is left is the metal layer used for solder film formation.

Metals that can be used for metal pattern formation include Au, Pt, Ni, and Co, and Pt, Ni, or Co is preferably used for the epi-surface layer of the metal pattern.

After the solder film is formed over the metal pattern, a film for protecting the solder film from oxidation, for example, can be formed over the solder film by vapor deposition or other method. Exemplary films of this sort include metal films of Au, Al, or In. The thickness of this protective layer is preferably 10 Å to 50 Å if made of Al, and 50 Å to 250 Å if made of In.

The present invention in a thirteenth aspect is a heat sink furnished with a solder film manufactured by a solder film manufacturing method described above, and is characterized in making available a heat sink for bare chip mounting of semiconductor devices.

A heat sink according to the twelfth aspect is desirably used for mounting, and particularly bare-chip mounting, semiconductor devices that are susceptible to thermal degradation, wherein the thirteenth aspect relates to this use. A typical example of this use is mounting bare laser-diode chips to the heat sink.

A fourteenth aspect of the invention affords a heat sink furnished with a solder film for fluxless mounting of semiconductor devices, and is characterized by the solder film being made up of Pb-free solder having a composition of 2 to 10 wt% Zn and 2 to 40 wt% Bi, with the remainder being Sn.

Solder made of Zn, Bi and Sn has conventionally been considered difficult to use without flux. In addition to the solder film manufacturing method and solder film described above, however, it was discovered that if the composition of Zn, Bi and Sn in the solder film is controlled to within a particular limits, a low melting point can be achieved and the problems of poor flow and wetting do not occur even in fluxless soldering using a solder made of Zn, Bi and Sn. Aheat sink having a solder film made of Pb-free solder containing 2 to 10 wt% Zn, 2 to 40 wt% Bi, with the remainder being Sn can therefore be used for fluxless mounting of semiconductor devices, and particularly for bare-chip mounting of laser diode chips. The fourteenth aspect of the invention was completed based on this discovery.

In a fifteenth aspect the invention affords a heat sink having a solder film for fluxlessly mounting semiconductor devices, and is characterized by the solder film being made up of Pb-free solder having a composition of 3 to 9 wt% Zn and 2 to 14 wt% Bi, with the remainder being Sn.

A Pb-free solder with a composition of 3 to 9 wt% Zn and 2 to 14 wt% Bi, with the remainder being Sn has a liquidus temperature of 195°C or less and a solidus temperature of 150°C or greater. A heat sink having a solder film of this composition is further preferable for bare-chip mounting of laser diode chips. The fifteenth aspect corresponds to this advantageous mode of the invention.

The present invention in a sixteenth aspect affords a heat sink having a solder film for fluxlessly mounting semiconductor devices, and is characterized by the solder film being made up of Pb-free solder having a composition of 5 to 7 wt% Zn and 8 to 14 wt% Bi, with the remainder being Sn.

A Pb-free solder with a composition of 5 to 7 wt% Zn and 8 to 14 wt% Bi, with the remainder being Sn has a liquidus temperature of approximately 185°C and a solidus temperature of 150°C or greater. More specifically, because at approximately 185°C the liquidus temperature is near that of conventional Sn-Pb eutectic solder, this composition is further preferable for a solder film for bare-chip mounting devices on a heat sink. A heat sink having a solder film of this composition is therefore even further preferably suited to bare-chip mounting of laser diode chips. The sixteenth aspect corresponds to this advantageous mode of the invention.

In a seventeenth aspect the invention affords a heat sink having a solder film for fluxless mounting semiconductor devices, and is characterized by the solder film being made up of Pb-free solder having a composition of 6 to 7 wt% Zn and 8 to 10 wt% Bi, with the remainder being Sn.

The liquidus temperature of this Pb-free solder composition is approximately 185°C, or near that of a conventional Sn-Pb eutectic solder, and the solidus temperature is approximately 160°C. This makes it possible to secondarily mount a heat sink furnished with this solder film onto which a laser diode chip is mounted, onto another heat sink at a temperature lower than 150°C to 160°C. This means that problems of inadequate bonding arising from deterioration in the bonding strength of the solder with which the laser diode chip is mounted are not liable to occur due to heat during the secondary mounting. Thus in this respect as well, a heat sink in the seventeenth aspect can be advantageously utilized, and is an especially preferred mode of a heat sink according to the present invention.

The Pb-free solder forming the solder film formed on a heat sink according to the present invention may contain trace amounts of other metals in addition to Zn, Bi and Sn. Examples of such other metals include Ge, Au, Ag, Cu, and In. Solder wetting can be improved, for example, by including 0.001 to 0.1 wt% Ge and 0.1 to 3 wt% Cu relative to the total amount of Zn, Bi and Sn.

The present invention in an eighteenth aspect affords a junction of a heat sink and a semiconductor device, characterized in including a heat sink according to the present invention, and a semiconductor device mounted on the solder film furnished on the heat sink.

As described above, semiconductor elements can be fluxlessly mounted onto a heat sink according to the present invention. The invention thus enables bare-chip mounting of semiconductor components onto a heat sink, wherein such semiconductor components include, to name one example, laser diode chips.

From the following detailed description in conjunction with the accompanying drawings, the foregoing and other objects, features, aspects and advantages of the present invention will become readily apparent to those skilled in the art.

Preferred embodiments of the present invention are described below, and it will be noted that the present invention is not to be limited by these embodiments.

### Embodiment 1

A metal pattern for solder film formation was formed by photolithographically patterning a resist layer with an inverted taper on an AlN substrate, forming a Au layer by vapor deposition, then dissolving the resist with an organic solvent, and lifting off the resist layer.

A resist layer with an inverted taper was then photolithographically patterned over the metal pattern, forming a solder pattern, and Zn, Sn, Bi, and Sn layers were vapor deposited in order.

The Zn, Sn, Bi, and Sn layers were vapor deposited by resistance heating using a vapor deposition system for vapor deposition using multiple boats. Source materials containing each element were loaded into each of the boats, and a unit layer of laminated Zn, Sn, Bi, Sn layers was produced by first depositing Zn, then depositing Sn, then depositing Bi, and then depositing Sn. The amount of source material is controlled so that the resulting film thicknesses are 350 Å, 3900 Å, 350 Å, and 300 Å, respectively.

The Zn, Sn, Bi, and Sn layers were 350 Å, 3900 Å, 350 Å, and 300 Å thick, respectively, as measured with a profilometer (Dektak). The desired layer thickness was thus achieved. Based on layer thickness and the specific gravity of the metals, the composition of the complete unit layer was calculated to be Sn-6.8 Zn-9.4 Bi.

The melting point of a unit layer of this solder film was measured by differential scanning calorimetry (DSC) to be 185°C, equal to the melting point of a ternary alloy solder of Sn-6.8 Zn-9.4 Bi. The DSC conditions were controlled to a 250 ml/min nitrogen flow and a temperature rise of 10°C/min.

This process of forming a unit layer composed of single Zn, Sn, Bi, Sn layers laminated in the order Zn, Sn, Bi, Sn was then repeated under the same conditions 5 times (performed a total 6 times) to produce a solder film approximately 3 µm thick. By then repeating the lift-off process, a solder film with high dimensional precision and high positioning precision was formed.

A bare chip (size: 300 µm x 300 µm x 200 µm) having an Au electrode surface on the mounting surface and an InP or GaAs laser diode was then mounted in the resultant solder film. A Nidek Toso CGD2000 was used for mounting in a N₂ atmosphere under the following conditions: weight, 18 g; preheat temperature, 100°C; peak temperature, melting point (liquidus temperature) +25°C (that is, 210°C in this embodiment); peak temperature hold time, 10 seconds.

Solder bond strength was measured after mounting using a die shear tester (Dazy 2400A-W100), and a 300 g strength was observed. This exceeds the chip failure strength of 200 g to 300 g, and was considered sufficient for practical application considering that a 100 g strength is sufficient to withstand wire bonding.

### Embodiment 2

An approximately 3 µm thick solder film was formed on a heat sink under the same conditions described in the first embodiment with the exception that an Sn-13.6 Zn alloy layer and then a Sn-18.8 Bi alloy layer were vapor deposited to a thickness of 2500 Å each in the unit layer, instead of depositing in order single laminae of Zn, Sn, Bi, Sn.

As a result, a solder film having an overall composition of Sn-6.8 Zn-9.4 Bi, the same melting point (185°C) as a ternary alloy solder of Sn-6.8 Zn-9.4 Bi, and sufficient solder bonding strength to withstand practical use, and a heat sink having this solder film formed thereon, were produced.

### Embodiment 3

An approximately 3 µm thick solder film was formed on a heat sink under the same conditions described in the first embodiment with the exception that instead of vapor depositing in order single laminae of Zn, Sn, Bi, Sn, layers of the same metals and same thickness were formed in the same order by plating.

As a result, a solder film having an overall composition of Sn-6.8 Zn-9.4 Bi, the same melting point (185°C) as a ternary alloy solder of Sn-6.8 Zn-9.4 Bi, and sufficient solder bonding strength to withstand practical use, and a heat sink having this solder film formed thereon, were produced.

### Embodiment 4

An approximately 3 µm thick solder film was formed on a heat sink under the same conditions described in the second embodiment with the exception that instead of vapor depositing in order an Sn-13.6 Zn alloy lamina and then a Sn-18.8 Bi alloy lamina, laminae of the same alloys and same thickness were formed in the same order by plating.

As a result, a solder film having an overall composition of Sn-6.8 Zn-9.4 Bi, the same melting point (185°C) as a ternary alloy solder of Sn-6.8 Zn-9.4 Bi, and sufficient solder bonding strength to withstand practical use, and a heat sink having this solder film formed thereon, were produced.

### Comparative Examples

An approximately 3 µm thick solder film was formed on a heat sink by vapor deposition under the same conditions described in the first embodiment except that Zn, Sn, Bi, Sn were vapor deposited to respective thicknesses of 2100 Å, 2340 Å, 2100 Å, and 1800 Å only once. As a result, the melting point was at least 225°C, and a Sn-6.8 Zn-9.4 Bi ternary solder film did not result. The solder also did not wet at all under the same mounting conditions used in the first embodiment, and bond strength was substantially zero.

### Reference Examples 1-6

Other than changing the amount of each deposited metal, solder films were formed under the same conditions described in the first embodiment. The composition, liquidus temperature, and solidus temperature of each solder film was then measured. The results are shown in the Table.

**Table**

| | Composition | Liquidus temp. (°C) | Solidus temp. (°C) |
|---|---|---|---|
| Ref. Ex. 1 | Sn-8.0 Zn-2.8 Bi | 190.1 | 181.9 |
| Ref. Ex. 2 | Sn-6.0 Zn-12.5 Bi | 181.3 | 151.4 |
| Ref. Ex. 3 | Sn-4.0 Zn-25.1 Bi | 169.0 | 136.1 |
| Ref. Ex. 4 | Sn-5.7 Zn-14.0 Bi | 179.9 | 148.3 |
| Ref. Ex. 5 | Sn-6.8 Zn-8.3 Bi | 185.1 | 162.5 |
| Ref. Ex. 6 | Sn-6.4 Zn-10.7 Bi | 183.0 | 155.9 |

It will thus be apparent that a solder film manufacturing method according to the present invention enables manufacturing a Pb-free solder film composed of Zn, Bi and Sn to a desirable composition and melting point by means of vapor deposition, plating, or other method without difficulty controlling the composition or melting point. When used in conjunction with photolithography, this method of our invention can form a solder film for mounting bare laser diode chips, for example, on a heat sink with excellent positioning precision.

Furthermore, a heat sink having a solder film according to the present invention enables bare chip mounting of semiconductor devices such as laser diode chips with excellent positioning precision without causing deterioration to the semiconductor device due to heat from the mounting process. The bond strength of the resulting solder junction can also sufficiently withstand practical use. Furthermore, a junction according to the present invention for bonding a semiconductor device to this heat sink is an excellent electronic component that can be used for mounting laser diodes and other semiconductor device applications.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A solder-film manufacturing method **characterized in** having a process for multi-laminating unit layers formed by laminating a plurality of types of laminae made from either Zn, Bi or Sn singly, or an alloy composed of two metals selected from Zn, Bi and Sn.

2. A solder-film manufacturing method as set forth in claim 1, **characterized in that** the unit layers are constituted substantially from Zn, Bi and Sn.

3. A solder-film manufacturing method as set forth in claim 2, **characterized in that** the laminar structure constituting the unit layers is substantially the same in each unit layer.

4. A solder-film manufacturing method **characterized in** including: a process of forming a single one of whichever of a Zn lamina, a Bi lamina, an Sn lamina, an alloy lamina of Zn and Sn, or an alloy lamina of Bi and Sn; a process of forming a unit layer composed of Zn, Bi and Sn by repeating the single-lamina formation process with the lamina being changed, and laminating the laminae; and a process of repeating the unit-layer formation process to laminate the unit layers.

5. A solder-film manufacturing method as set forth in claim 4, **characterized in that** the process of forming the unit layer is made up of the steps of forming laminae in the order Zn lamina, Sn lamina, Bi lamina, Sn lamina, or the order Bi lamina, Sn lamina, Zn lamina, Sn lamina.

6. A solder-film manufacturing method as set forth in claim 4, **characterized in that** the process of forming the unit layer includes the step of forming an alloy lamina of Zn and Sn, and/or a step of forming an alloy lamina of Bi and Sn.

7. A solder-film manufacturing method as set forth in any of claims 1 though 6, **characterized in** including a step of forming an Sn lamina on the epi-surface layer of the solder film.

8. A solder-film manufacturing method as set forth in any of claims 1 though 7, **characterized in that** the unit layers are formed by vapor deposition.

9. A solder-film manufacturing method as set forth in any of claims 1 though 7, **characterized in that** the unit layers are formed by plating.

10. A solder-film manufacturing method as set forth in any of claims 1 though 9, **characterized in that** the unit layer thickness is 8000 Å or less.

11. A solder-film manufacturing method as set forth in any of claims 1 though 10, **characterized in** including a step of forming a solder film on a patterned resist layer, and patterning the solder film by a lift-off technique after the solder film is formed.

12. A heat sink furnished with a solder film manufactured according to the solder-film manufacturing method set forth in any of claims 1 through 11.

13. A heat sink furnished with the solder film set forth in claim 12, **characterized in** being for bare-chip mounting of semiconductor devices.

14. A heat sink furnished with a solder film being for mounting semiconductor devices mounted fluxlessly, and **characterized by** the solder film being composed of Pb-free solder having a composition of 2 to 10 wt% Zn and 2 to 40 wt% Bi, with the remainder being Sn.

15. A heat sink furnished with a solder film being for mounting semiconductor devices mounted fluxlessly, and **characterized by** the solder film being composed of Pb-free solder having a composition of 3 to 9 wt% Zn and 2 to 14 wt% Bi, with the remainder being Sn.

16. A heat sink furnished with a solder film being for mounting semiconductor devices mounted fluxlessly, and **characterized by** the solder film being composed of Pb-free solder having a composition of 5 to 7 wt% Zn and 8 to 14 wt% Bi, with the remainder being Sn.

17. A heat sink furnished with a solder film being for mounting semiconductor devices mounted fluxlessly, and **characterized by** the solder film being composed of Pb-free solder having a composition of 6 to 7 wt% Zn and 8 to 10 wt% Bi, with the remainder being Sn.

18. A junction of a heat sink and a semiconductor device, **characterized in** including a heat sink as set forth in any of claims 14 through 17, and a semiconductor device mounted on the solder film furnished on the heat sink.
